(19) Europäisches Patentamt / European Patent Office / Office européen des brevets

(11) **EP 4 317 065 A1**

(12) **EUROPEAN PATENT APPLICATION**
published in accordance with Art. 153(4) EPC

(43) Date of publication:
**07.02.2024  Bulletin 2024/06**

(21) Application number: **22780354.1**

(22) Date of filing: **23.03.2022**

(51) International Patent Classification (IPC):
$C01B\ 33/12$ [(2006.01)]       $C01B\ 33/18$ [(2006.01)]
$H01L\ 23/29$ [(2006.01)]       $H01L\ 23/31$ [(2006.01)]

(52) Cooperative Patent Classification (CPC):
**C01B 33/12; C01B 33/18; H01L 23/29; H01L 23/31**

(86) International application number:
**PCT/JP2022/013370**

(87) International publication number:
**WO 2022/210139 (06.10.2022 Gazette 2022/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.03.2021   JP 2021059394**

(71) Applicant: **Denka Company Limited
Tokyo 103-8338 (JP)**

(72) Inventors:
• **HATAYAMA, Yasuaki
  Tokyo 103-8338 (JP)**
• **FUKUDA, Takashi
  Tokyo 103-8338 (JP)**

(74) Representative: **Murgitroyd & Company
Murgitroyd House
165-169 Scotland Street
Glasgow G5 8PL (GB)**

(54) **INORGANIC OXIDE POWDER**

(57)    [Problem] To provide an inorganic oxide powder in which few air bubbles are contained in the particles and a production method for the inorganic oxide powder.

[Solution] A spherical inorganic oxide powder wherein a volume-based cumulative 50% diameter $D_{50}$ is 4-55 $\mu$m; and in a cross-section of a cured body containing an epoxy resin and the spherical inorganic oxide powder at a mass ratio of 2:1, when a total of 5000 particles with a maximum diameter of 5 $\mu$m or larger are observed in a field of view at 100$\times$ magnification using a scanning electron microscope, a total number of air bubbles having a maximum diameter of 1 $\mu$m or larger and smaller than 10 $\mu$m is 40 or fewer and a total number of air bubbles having a maximum diameter of 10 $\mu$m or larger is 30 or fewer.

[FIG. 1]

EP 4 317 065 A1

**Description**

**TECHNICAL FIELD**

The present invention relates to an inorganic oxide powder.

**BACKGROUND**

In recent years, semiconductor packages have become increasingly smaller, thinner, and higher in density in response to trends towards compactness/lightness and high performance in electronic devices. Additionally, the mounting methods thereof are coming to be dominated by surface mounting that is appropriate for high-density mounting on wiring boards, etc. As such advances are made in semiconductor packages and mounting methods thereof, there are demands for higher performance in semiconductor encapsulating materials, particularly in terms of functional improvements such as those in solder heat resistance, moisture resistance, low thermal expansion, mechanical properties, electrical insulation properties, etc. In order to satisfy these demands, resin compositions obtained by filling a resin with an inorganic oxide powder, particularly an amorphous silica powder, are being used.

As amorphous silica powders, spherical amorphous silica powders obtained by spraying a raw material powder into high-temperature flames, thus melting and amorphizing the powder, are known (for example, Patent Document 1). In spherical amorphous silica obtained by a melt method, gaps (air bubbles) can sometimes be taken into the particles. As a technology for reducing the amount of air bubbles, Patent Document 2 describes a method in which hydrophobically treated fumed silica is used as a raw material and is melted to form spheres under specific combustion conditions.

**CITATION LIST**

**PATENT LITERATURE**

Patent Document 1: JP 2010-285307 A

Patent Document 2: WO 2019/167618 A

**SUMMARY OF INVENTION**

**TECHNICAL PROBLEM**

For the purposes of cost reduction, using a mineral-derived raw material is preferred. Additionally, particles with a large particle diameter (for example, particles with a particle diameter of 5 $\mu$m or larger) are preferably included so as to allow the resin to be filled with a high content of the particles. However, particles with a large particle diameter tend to more easily take in air bubbles.

A problem addressed by the present invention is to provide an inorganic oxide powder in which few air bubbles are contained in the particles and a production method for the inorganic oxide powder.

**SOLUTION TO PROBLEM**

The present inventors discovered that a spherical inorganic oxide powder having few air bubbles in the particles can be obtained by once melting a raw material at a high temperature of 1600 °C before it has been formed into spheres by a melt method, then pulverizing and classifying the material to obtain amorphous crushed silica, thereby completing the present invention.

The present invention has the embodiments below.

[1] A spherical inorganic oxide powder wherein:

a volume-based cumulative 50% diameter $D_{50}$ is 4-55 $\mu$m; and

in a cross-section of a cured body containing an epoxy resin and the spherical inorganic oxide powder at a mass ratio of 2:1, when a total of 5000 particles with a maximum diameter of 5 $\mu$m or larger are observed in a field of view at 100$\times$ magnification using a scanning electron microscope, a total number of air bubbles having a maximum diameter of 1 $\mu$m or larger and smaller than 10 $\mu$m is 40 or fewer, and a total number of air bubbles having a maximum diameter of 10 μm or larger is 30 or fewer.

[2] The spherical inorganic oxide powder according to [1], wherein, in a cross-section of a cured body containing an epoxy resin and the spherical inorganic oxide powder at a mass ratio of 2:1, when a total of 5000 particles with a maximum diameter of 5 μm or larger are observed in a field of view at 100× magnification using a scanning electron microscope, 1000 or more particles having a maximum diameter of 20 μm or larger are observed.

[3] The spherical inorganic oxide powder according to [1] or [2], wherein, in a cross-section of a cured body containing an epoxy resin and the spherical inorganic oxide powder at a mass ratio of 2:1, when a total of 1000 particles with a maximum diameter of 20 μm or larger are observed in a field of view at 100× magnification using a scanning electron microscope, a total number of air bubbles having a maximum diameter of 1 μm or larger and smaller than 10 μm is 40 or fewer, and a total number of air bubbles having a maximum diameter of 10 μm or larger is 30 or fewer.

[4] The spherical inorganic oxide powder according to any one of [1] to [3], wherein the volume-based cumulative 50% diameter $D_{50}$ is 7.5 μm or larger.

[5] The spherical inorganic oxide powder according to any one of [1] to [4], having at least two peaks in a volume-based particle size frequency distribution.

[6] The spherical inorganic oxide powder according to any one of [1] to [5], satisfying one or more conditions selected from the following:

- the U content is 10 ppb or less;
- the Th content is 20 ppb or less;
- the Fe content is 200 ppm or less; and
- the Al content is 1 mass% or less.

[7] A production method for a spherical inorganic oxide powder according to any one of [1] to [6], wherein the production method includes:

(i) retaining a raw material containing an inorganic oxide for 3 hours or more under conditions with a pressure of 0.9-1.5 atm and a temperature of 1600 °C or higher to obtain a melted material, and after cooling the melted material, pulverizing and classifying the material to obtain a crushed powder; and
(ii) thermally spraying the amorphous powder into a flame with a flame temperature of 1600 °C or higher to obtain a spherical inorganic oxide powder,

thereby obtaining a spherical inorganic oxide powder having a volume-based cumulative 50% diameter $D_{50}$ of 4-55 μm.

[8] The production method according to [7], including, before step (i), pulverizing a mineral and/or an ore containing the inorganic oxide to obtain the raw material.

## EFFECTS OF INVENTION

The present invention can provide an inorganic oxide powder in which few air bubbles are contained in the particles, and a production method for the inorganic oxide powder.

## BRIEF DESCRIPTION OF DRAWINGS

FIG. 1 is a scanning electron microscope photograph (300× magnification) of a cross-section of a test piece for evaluating air bubbles using the spherical amorphous silica powder of Example 1.

FIG. 2 is a scanning electron microscope photograph (300× magnification) of a cross-section of a test piece for evaluating air bubbles using the spherical amorphous silica powder of Comparative Example 1.

**DESCRIPTION OF EMBODIMENTS**

Hereinafter, an embodiment of the present invention will be explained in detail. The present invention is not limited to the embodiment below and can be implemented by adding modifications, as appropriate, within a range not hindering the effects of the present invention.

[Spherical inorganic oxide powder] The spherical inorganic oxide powder according to the present embodiment has a volume-based cumulative 50% diameter $D_{50}$ of 4-55 $\mu$m, and in a cross-section of a cured body containing an epoxy resin and the spherical inorganic oxide powder at a mass ratio of 2:1, when a total of 5000 particles with a maximum diameter of 5 $\mu$m or larger are observed in a field of view at 100$\times$ magnification using a scanning electron microscope, the total number of air bubbles having a maximum diameter of 1 $\mu$m or larger and smaller than 10 $\mu$m is 40 or fewer and the total number of air bubbles having a maximum diameter of 10 $\mu$m or larger is 30 or fewer. The spherical inorganic oxide powder is composed of spherical particles of an inorganic oxide.

The term "spherical" means that, when observed at 100$\times$ magnification using a scanning electron microscope, a circular or round particle shape is observed. A spherical inorganic oxide powder can be obtained by melting a raw material inorganic oxide powder and forming spheres therefrom (melt method).

The spherical inorganic oxide powder is one wherein, when a total of 5000 particles with a maximum diameter of 5 $\mu$m or larger are observed in a cross-section of a prescribed test piece, the total number of air bubbles having a maximum diameter of 1 $\mu$m or larger and smaller than 10 $\mu$m is 40 or fewer and the total number of air bubbles having a maximum diameter of 10 $\mu$m or larger is 30 or fewer. Thus, even in the case in which particles with a large particle diameter are included, there are few air bubbles in the particles. Since there are few air bubbles in the particles, electrical discharge effects can be prevented from occurring when a high-voltage electric current is applied, even in the case in which the particles are present at the surface of an encapsulating material. Additionally, even when the surface of the encapsulating material is cut, there do not tend to be step differences due to air bubbles and the smoothness can be maintained.

Since the spherical inorganic oxide powder has a volume-based cumulative 50% diameter $D_{50}$ of 4-55 $\mu$m, a resin can be filled with a high content thereof. Additionally, since 5000 particles that are 5 $\mu$m or larger can be observed in a cross-section of the test piece, many particles with a large particle diameter are included, and the resin can be filled with a high content thereof.

The terminology "volume-based cumulative 50% diameter $D_{50}$" refers to the particle diameter corresponding to a cumulative value of 50% in a volume-based cumulative particle size distribution measured by a laser diffraction/scattering method (refractive index: 1.50). The cumulative particle size distribution is represented by a distribution curve with the particle diameter ($\mu$m) on the horizontal axis and the cumulative value (%) on the vertical axis. The volume-based cumulative particle size distribution measured by a laser diffraction/scattering method (refractive index: 1.50) is measured, for example, by using a laser diffraction/scattering-type particle size distribution measuring apparatus ("LS-230" manufactured by Beckman-Coulter Inc.), with water (refractive index: 1.33) as the solvent, and by performing a dispersion treatment by using an "Ultrasonic Disruptor UD-200 (with a microtip TP-040 attached)" manufactured by Tomy Seiko Co., Ltd. to apply a 200 W output for 2 minutes as a pretreatment.

The volume-based cumulative 50% diameter $D_{50}$ is 4-55 $\mu$m, and for the purpose of allowing the resin to be filled with a higher content of the particles, should preferably be 4-54 $\mu$m, more preferably 7.5-53 $\mu$m, and even more preferably 8-53 $\mu$m.

In one embodiment, the volume-based cumulative 50% diameter $D_{50}$ may be 4.2-52.8 $\mu$m. In one embodiment, the volume-based cumulative 50% diameter $D_{50}$ may be 7.5 $\mu$m or larger. In one embodiment, the volume-based cumulative 50% diameter $D_{50}$ may be larger than 10 $\mu$m and equal to or smaller than 55 $\mu$m, larger than 20 $\mu$m and equal to or smaller than 55 $\mu$m, or 30-55 $\mu$m.

The volume-based cumulative 50% diameter $D_{50}$ may be adjusted by adjusting the particle diameter of the raw material powder, or by adjusting the volume-based cumulative 50% diameter $D_{50}$ to a prescribed value by classifying (by sieve classification or by an air classifier) the powder after forming the spheres.

Examples of inorganic oxide powders include metal oxide powders. Examples of metal oxide powders include silica ($SiO_2$), alumina ($Al_2O_3$), titania ($TiO_2$), magnesia (MgO), calcia (CaO), etc. The inorganic oxide powder preferably includes one or more metal oxide powders selected from the above and more preferably includes spherical silica. Spherical amorphous silica produced by a method of melting crystalline silica at a high temperature is preferable for the purpose of bringing the thermal expansion coefficients of a semiconductor chip and a liquid encapsulating material close to each other, and for solder heat resistance, moisture resistance, and reducing the wear on dies.

The spherical inorganic oxide powder is one wherein, when a total of 5000 particles with a maximum diameter of 5 $\mu$m or larger are observed in a cross-section of a prescribed test piece, the total number of air bubbles having a maximum diameter of 1 $\mu$m or larger and smaller than 10 $\mu$m is 40 or fewer, preferably 20 or fewer, more preferably 10 or fewer, and even more preferably 7 or fewer, and the total number of air bubbles having a maximum diameter of 10 $\mu$m or larger is 30 or fewer, preferably 20 or fewer, more preferably 10 or fewer, and even more preferably 4 or fewer.

Thus, according to the spherical inorganic oxide powder of the present embodiment, both fine air bubbles and air bubbles with a maximum diameter of 10 μm or larger are made fewer. It is preferable for there to be as few of both types of air bubbles as possible, and it is preferable for there to be zero of either type.

The term "maximum diameter" refers to the maximum distance among the distances between two arbitrary points on the outer circumference (outline) of a particle. The maximum diameter can be measured by using a scanning electron microscope and image processing software.

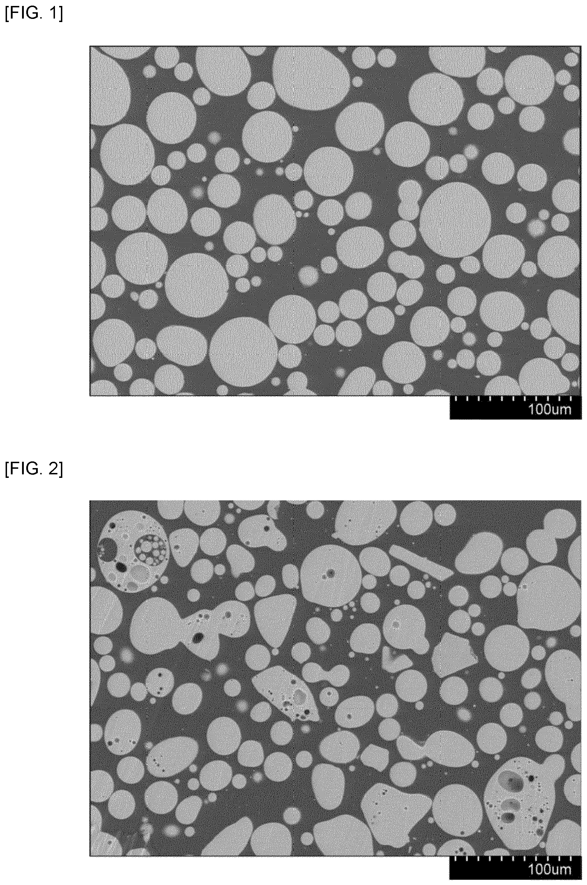

The "number of air bubbles" is measured visually by counting the number of voids observed in cross-sections of particles, which appear white in scanning electron microscope photographs. For example, in the scanning electron microscope photograph of the cross-section of the test piece using the spherical amorphous silica powder of Comparative Example 1 indicated in FIG. 2, the round or elliptical portions in gray or black or the portions outlined in white seen in the cross-sections of the particles appearing white are voids.

The test pieces are cured bodies containing an epoxy resin and a spherical inorganic oxide powder at a mass ratio of 2:1.

The production method of the cured bodies is to mix the epoxy resin and the spherical inorganic oxide powder so as to have a mass ratio of 2:1 (i.e., to mix 50 parts by weight of the spherical inorganic oxide powder with respect to 100 parts by weight of the epoxy resin), and to knead the mixture until uniform. An embedded molding die is filled with the kneaded material so as not to introduce air bubbles and after performing vacuum deaeration, the material is cured by heating at 90 °C for 90 minutes or longer.

In a cross-section of the cured body, a total of 5000 of the particles with a maximum diameter of 5 μm or larger are observed in a field of view at 100× magnification using a scanning electron microscope.

The "cross-section" is one or more faces cut at an arbitrary location on the cured body. In one embodiment, the cross-section is one or two faces cut at a single arbitrary location on a cured body. In one embodiment, the cross-section is a face obtained by cutting the cured body vertically along a line connecting the centers of long sides. The observation face may also be polished.

The cross-section is observed at 100× magnification using a scanning electron microscope in one or more fields of view until the number of particles having a maximum diameter of 5 μm or larger becomes 5000, and the number of air bubbles is counted visually.

In one embodiment, the spherical inorganic oxide powder is one wherein, in a cross-section cut at one arbitrary location on a cured body with a size produced in an embedded molding die having internal dimensions of 12 mm × 5 mm × 3 mm, when a total of 5000 particles with a maximum diameter of 5 μm or larger are observed in a field of view at 100× magnification using a scanning electron microscope, the total number of air bubbles having a maximum diameter of 1 μm or larger and smaller than 10 μm is 40 or fewer and the total number of air bubbles having a maximum diameter of 10 μm or larger is 30 or fewer.

In one embodiment, the spherical inorganic oxide powder is one wherein, when a total of 5000 particles with a maximum diameter of 5 μm or larger are observed in a cross-section of a prescribed test piece, the number of particles observed with a maximum diameter of 20 μm or larger is preferably 1000 or more, more preferably 1200-2000, and even more preferably 1200-2500.

In other words, in the spherical inorganic oxide powder, when 5000 particles of 5 μm or larger are observed, there are preferably 1000 or more, more preferably 1200-2000, and even more preferably 1200-2500 particles with a maximum diameter of 20 μm or larger. By including many particles having a maximum diameter of 20 μm or larger, the resin can be filled with a higher content thereof. Even in the case in which many particles having a maximum diameter of 20 μm or larger are included, the number of air bubbles observed in a cross-section of a prescribed test piece is small. Thus, the spherical inorganic oxide powder can be considered to be one in which there are few air bubbles in the particles.

In one embodiment, the spherical inorganic oxide powder is one wherein, in a cross-section of a cured body containing an epoxy resin and the spherical inorganic oxide powder at a mass ratio of 2:1, when a total of 1000 particles with a maximum diameter of 20 μm or larger are observed in a field of view at 100× magnification using a scanning electron microscope, the total number of air bubbles having a maximum diameter of 1 μm or larger and smaller than 10 μm is 40 or fewer, preferably 20 or fewer, more preferably 10 or fewer, and even more preferably 7 or fewer and the total number of air bubbles having a maximum diameter of 10 μm or larger is 30 or fewer, preferably 20 or fewer, more preferably 10 or fewer, and even more preferably 4 or fewer. The spherical inorganic oxide powder has a small number of air bubbles even in the case in which many particles of 20 μm or larger are included in a cross-section of a test piece.

The spherical inorganic oxide powder has at least one peak in a volume-based particle size frequency distribution, preferably has at least two peaks, and may have three or more peaks. By having at least two peaks, the resin can be filled with a higher content of the particles.

The "volume-based particle size frequency distribution" refers to a volume-based particle size frequency distribution measured by a laser diffraction/scattering method (refractive index: 1.50). The cumulative particle size distribution is represented by a distribution curve with the particle diameter (μm) on the horizontal axis and the frequency (%) on the vertical axis.

A "peak" refers to a curve having a boundary (local maximum value) at which the slope of the curve changes from positive to negative in the volume-based particle size frequency distribution, and in the case in which there is a shoulder (a portion in which there is a bulge or a step along the slope of the curve constituting a single peak), the shoulder is included as a single peak.

In one embodiment, the spherical inorganic oxide powder preferably has peaks, respectively, at particle diameters smaller than 10 $\mu$m and within the range 10-20 $\mu$m in a volume-based particle size frequency distribution. Since there is a peak in each of these ranges, the resin can be filled with a higher content of the particles.

In one embodiment, the spherical inorganic oxide powder has local maximum values, respectively, at particle diameters smaller than 10 $\mu$m and within the range 10-20 $\mu$m in a volume-based particle size frequency distribution.

For the purpose of lowering the viscosity when the resin is mixed, the spherical inorganic oxide powder preferably has an average sphericity of 0.85 or higher, more preferably 0.90 or higher, and even more preferably 0.95 or higher. The "average sphericity" is a value measured by using a powder image analyzer (FPIA-3000). Specifically, after dispersing the sample in purified water, the liquid is flowed in a planar elongational flow cell, 100 or more amorphous silica particles moving in the cell are recorded as images using an objective lens, and the average sphericity is calculated from the recorded images and the following expression (1).

$$\text{Expression (1): Average sphericity} = \pi \cdot \text{HD/PM}$$

In Expression (1), HD represents the circle equivalent diameter, which is determined from the area ratio between the projected area of a target particle and a perfect circle. PM represents the projected perimeter of the target particle. The average value for 200 amorphous silica particles calculated in this way is the average sphericity.

From this average sphericity, the average sphericity is determined by the expression: Average sphericity = (average circularity)$^2$.

In the spherical inorganic oxide powder, for the purpose of reducing impurities, the U content is preferably 10 ppb or less in the spherical inorganic oxide powder, the Th content is preferably 20 ppb or less in the spherical inorganic oxide powder, the Fe content is preferably 200 ppm or less in the spherical inorganic oxide powder, and/or the Al content is 1 mass% or less (10000 ppm or less) in the spherical inorganic oxide powder.

In one embodiment, one or more of the conditions selected from the following are preferably satisfied:

- the U content is 10 ppb or less;

- the Th content is 20 ppb or less;

- the Fe content is 200 ppm or less; and

- the Al content is 1 mass% or less.

More preferably, all of the above conditions are satisfied.

The U content in the spherical inorganic oxide powder is more preferably 0.1-10 ppb, even more preferably 0.1-8 ppb, and may be 0.2-8 ppb.

The Th content in the spherical inorganic oxide powder is more preferably 0.1-20 ppb, even more preferably 0.1-15 ppb, and may be 0.2-15 ppb.

The Fe content in the spherical inorganic oxide powder is more preferably 10-200 ppm, even more preferably 10-120 ppm, and may be 15-120 ppm.

The Al content in the spherical inorganic oxide powder is more preferably 1-9000 ppm (0.9 mass%) and may be 10-9000 ppm or 100-9000 ppm.

In one embodiment, the spherical inorganic oxide powder contains 140-8120 ppm of Al.

The content of the above-mentioned impurities was measured by using an inductively coupled plasma mass spectrometer (ICP-MS).

The spherical inorganic oxide powder can be used by being mixed with another spherical inorganic oxide powder having a different particle diameter. By forming a mixture with another spherical inorganic oxide powder having a different particle diameter, the resin can be filled with a higher content of the particles.

(Use)

The spherical inorganic oxide powder according to the present embodiment can be used to produce a material such as a semiconductor encapsulating material. In particular, since there are few air bubbles in the particles, it can be favorably used to produce semiconductor encapsulating materials for use in electronic devices.

[Production method]

The production method of the spherical inorganic oxide powder according to the present embodiment includes:

(i) retaining a raw material containing an inorganic oxide for 3 hours or more under conditions with a pressure of 0.9-1.5 atm and a temperature of 1600 °C or higher to obtain a melted material, and after cooling the melted material, pulverizing and classifying the material to obtain an amorphous powder; and
(ii) thermally spraying the amorphous powder into a flame with a flame temperature of 1600 °C or higher to obtain a spherical inorganic oxide powder,

thereby obtaining a spherical inorganic oxide powder having a volume-based cumulative 50% diameter $D_{50}$ of 4-55 $\mu$m.

(Step (i): Melt pulverization step)

In step (i), a raw material containing an inorganic oxide is retained for 3 hours or more under conditions with a pressure of 0.9-1.5 atm (preferably 0.9-1.0 atm) and a temperature of 1600 °C or higher (preferably 1650 °C or higher, more preferably 1700 °C or higher) to obtain a melted material, and after cooling the melted material, pulverizing and classifying the material to obtain a crushed powder. A powder with a prescribed particle diameter can be obtained by classification. By performing step (i) for melt-pulverizing the raw material before the sphere-forming step (ii) explained below, the air bubbles in the particles of the finally obtained spherical inorganic oxide powder can be reduced. Such knowledge was not recognized until now.
As the "inorganic oxide", materials that are the same as those described regarding the spherical inorganic oxide powder above can be used. Thus, the raw material is preferably a crushed mineral and/or ore. The production method for the spherical inorganic oxide powder according to the present embodiment may, as needed, have a step (i') of crushing a mineral or ore to obtain a raw material before step (i). Examples of the mineral or ore include silica sand, silica stone, bauxite, rutile ore, talc, limestone, etc.
The average particle diameter of the raw material is not limited and may be selected, as appropriate, for the purposes of workability.
The inorganic oxide content in the raw material (the purity of the raw material) is preferably 80 mass% or higher, more preferably 90 mass% or higher, and even more preferably 95 mass% or higher. The purity of the raw material is a value obtained by using a fluorescent X-ray spectrometer to determine the quantity based on calibration curves prepared in advance based on X-ray intensities.
The raw material is supplied, for example, to a firing furnace such as a rotary kiln and retained for 3 hours or more under conditions with a pressure of 0.9-1.5 atm and a temperature of 1600 °C or higher to obtain a melted material. By retaining the raw material for 3 hours or more under conditions with a pressure of 0.9-1.5 atm and a temperature of 1600 °C or higher, the air bubbles in the raw material can be reduced.
The raw material processing conditions are preferably such that the pressure is standard pressure (1 atm) and the temperature is 1650 °C or higher, more preferably 1700 °C or higher, and the raw material is retained preferably for 3.5 hours or more, and more preferably for 4 hours or more to obtain the melted material.
Thereafter, the melted material is cooled to room temperature (for example, 25 °C), then pulverized and classified to obtain an amorphous powder.
The pulverization method is not limited and the material may be pulverized with a known pulverizer.
The classification method involves classifying the powder by using a sieve-type classifier, an air classifier, etc. so that a desired particle diameter is obtained and recovering an amorphous powder.
The average particle diameter (volume-based cumulative 50% diameter $D_{50}$) of the spherical inorganic oxide powder can be adjusted by pulverizing and classifying the powder in step (i), or by classifying the powder, as needed, in step (ii). For this reason, the powder is preferably pulverized and classified in step (i) so that the average particle diameter of the spherical inorganic oxide powder becomes a desired average particle diameter.
The method for adjusting the average particle diameter of the amorphous powder may involve adjusting the sieve mesh size, the air speed, etc., or adjusting the temperature during classification.

(Step (ii): Sphere-forming step)

In step (ii), the amorphous powder obtained as described above is thermally sprayed into a flame with a flame temperature of 1600 °C or higher to obtain a spherical inorganic oxide powder.
Specifically, according to the methods described in JP S58-145613 A, JP S59-59737 A, JP S61-234922 A, JP H6-56445 A, etc., an amorphous powder is sprayed into a vertical furnace together with a flammable gas and a supporting gas supplied by using a burner, thereby dispersing the powder in a high-temperature flame with a flame temperature of 1600 °C or higher, melting the powder and forming spheres.

As the amorphous powder, a mixture of multiple powders with different volume-based cumulative 50% diameters $D_{50}$ may be used.

As the flammable gas, a hydrocarbon-based gas such as methane, acetylene, ethylene, propane, butane, etc.; hydrogen gas; or a liquid fuel such as kerosene or heavy oil may be used. As the supporting gas, oxygen, an oxygen-rich cooling gas, or air may be used.

The flame temperature is 1600 °C or higher, preferably 1650 °C or higher, and more preferably 1700 °C or higher. The flame temperature can be adjusted by adjusting the types and gas supply amounts of the flammable gas and the supporting gas that are used.

Thereafter, the powder is classified, as needed, while cooling the powder to room temperature (for example, 25 °C) and the powder is collected to obtain a sphere-shaped powder (spherical inorganic oxide powder) having a volume-based cumulative 50% diameter $D_{50}$ of 4-55 μm. As the classification method that is performed as needed, a method that is the same as the method in the above step (i) can be used. The method for measuring the "volume-based cumulative 50% diameter $D_{50}$", the preferable range, and the adjustment method are as described above.

Additionally, a spherical inorganic oxide powder having at least two peaks in the volume-based particle size frequency distribution can be produced, for example, by producing and mixing together a spherical inorganic oxide powder having a small average particle diameter and a spherical inorganic oxide powder having a large average particle diameter.

**EXAMPLES**

The present invention will be more specifically explained by indicating examples below. However, these examples should not be construed as limiting the present invention.

(Production Example 1: Raw Material Powder 1)

A raw material obtained by pulverizing natural silica stone with a purity of 90% or higher was loaded into a rotary kiln and retained for 4 hours at 1.0 atm and 1650 °C to obtain a melted material. The melted material was cooled to 25 °C, then pulverized and further classified to obtain an amorphous raw material powder 1 having a volume-based cumulative 50% diameter $D_{50}$ of 50 μm.

(Production Example 2: Raw Material Powder 2)

An amorphous raw material powder 2 was obtained by the same method as Production Example 1, except that the powder was pulverized and classified so that the volume-based cumulative 50% diameter $D_{50}$ was 5 μm.

(Comparative Raw Material Powders 3 and 4)

Natural silica stone having a purity of 90% or higher was pulverized and classified to obtain a comparative raw material powder 3 (50 μm) and a comparative example raw material powder 4 (5 μm) having a volume-based cumulative 50% diameter $D_{50}$ of 50 μm or 5 μm.

[Example 1]

The amorphous raw material powder 1 obtained in Production Example 1 was supplied to a 2000 °C flame formed by burning LPG and oxygen using an apparatus having a vertical furnace with a burner installed in a furnace top portion and having a lower portion connected to a collection apparatus (bag filter), thereby melting the powder and forming spheres. Thereafter, the powder was classified to obtain a spherical amorphous silica powder as the spherical inorganic oxide powder. The volume-based cumulative 50% diameter $D_{50}$ of the obtained spherical amorphous silica powder was 38.7 μm. The method for measuring the volume-based cumulative 50% diameter $D_{50}$ will be explained below.

[Examples 2 and 3]

Spherical amorphous silica powders were obtained by the same method as in Example 1, except that the powders were classified so that the $D_{50}$ was as indicated in Table 1.

[Examples 4-6]

Spherical amorphous silica was obtained by the same method as in Example 1, except that raw material powder 2 was used and the powders were classified so that $D_{50}$ was as indicated in Table 1.

[Examples 7-9]

Example 7 was produced by mixing the spherical amorphous silica of Example 1 with the spherical amorphous silica of Example 4 so that $D_{50}$ was as indicated in Table 1.
Example 8 was produced by mixing the spherical amorphous silica of Example 2 with the spherical amorphous silica of Example 5 so that $D_{50}$ was as indicated in Table 1.
Example 9 was produced by mixing the spherical amorphous silica of Example 3 with the spherical amorphous silica of Example 6 so that $D_{50}$ was as indicated in Table 1.

[Comparative Example 1]

A spherical amorphous silica powder was obtained by the same method as in Example 1, except that comparative raw material powder 3 was used. The volume-based cumulative 50% diameter $D_{50}$ was measured in the same manner as in Example 1.

[Comparative Examples 2 and 3]

Spherical amorphous silica powders were obtained by the same method as in Comparative Example 1, except that the powders were classified so that $D_{50}$ was as indicated in Table 1.

[Comparative Examples 4-6]

Spherical amorphous silica was obtained by a method similar to Example 1, except that comparative raw material 4 was used and the powders were classified so that $D_{50}$ was as indicated in Table 1.

[Comparative Examples 7-9]

Comparative Example 7 was produced by mixing the spherical amorphous silica of Comparative Example 1 with the spherical amorphous silica of Comparative Example 4 so that $D_{50}$ was as indicated in Table 1.
Comparative Example 8 was produced by mixing the spherical amorphous silica of Comparative Example 2 with the spherical amorphous silica of Comparative Example 5 so that $D_{50}$ was as indicated in Table 1.
Comparative Example 9 was produced by mixing the spherical amorphous silica of Comparative Example 3 with the spherical amorphous silica of Comparative Example 6 so that $D_{50}$ was as indicated in Table 1.

[Measurement]

(Volume-based cumulative 50% diameter $D_{50}$)

The volume-based cumulative 50% diameter $D_{50}$ of the spherical amorphous silica powders of the examples and the comparative examples were determined by measuring the cumulative particle size distribution with a laser diffraction/scattering method (refractive index: 1.50) using a laser diffraction/scattering-type particle size distribution measuring apparatus ("LS-230" manufactured by Beckman-Coulter Inc.), with water (refractive index: 1.33) as the solvent, and by performing a dispersion treatment by using an "Ultrasonic Disruptor UD-200 (with a microtip TP-040 attached)" manufactured by Tomy Seiko Co., Ltd. to apply a 200 W output for 2 minutes as a pretreatment.

(Particle size frequency distribution)

The volume-based particle size frequency distributions of the spherical amorphous silica powders of the examples and the comparative examples were measured by a laser diffraction/scattering method (refractive index: 1.50) using a laser diffraction/scattering-type particle size distribution measuring apparatus ("LS-230" manufactured by Beckman-Coulter Inc.), with water (refractive index: 1.33) as the solvent, and by performing a dispersion treatment by using an "Ultrasonic Disruptor UD-200 (with a microtip TP-040 attached)" manufactured by Tomy Seiko Co., Ltd. to apply a 200 W output for 2 minutes as a pretreatment. The number of peaks in the obtained particle size frequency distribution was counted visually and indicated in Table 1.

(Number of air bubbles)

50 parts by mass of a spherical amorphous silica powder were mixed with 100 parts by mass of an epoxy resin and the mixture was kneaded until uniform. Next, an embedded molding die (internal dimensions:12 mm × 5 mm × 3 mm) was filled with the kneaded material so as not to introduce air bubbles and the material was vacuum-deaerated, then well cured under conditions with a temperature of 90 °C for 90 minutes or longer. As the epoxy resin, G-2 grade epoxy resin manufactured by Gatan, Inc. was used.

Next, the cured body was cut vertically at the center of a long side to obtain an observation face. The observation face that was obtained was observed (in one or more fields of view) at 100× magnification using a scanning electron microscope until a total of 5000 particles having a maximum diameter (the maximum straight-line distance between two arbitrary points on an outline of a particle) of 5 μm or larger were observed. Then, the number of air bubbles having a maximum diameter of 1 μm or larger and smaller than 10 μm, the number of air bubbles having a maximum diameter of 10 μm or larger, and the number of air bubbles having a maximum diameter of 20 μm or larger were counted visually. In the case in which one silica particle had multiple air bubbles, these were counted as multiple air bubbles. The results are indicated in Table 1. Regarding the number of particles having a maximum diameter of 20 μm or larger, among the 5000 total particles that were 5 μm or larger, approximately 500 were confirmed in Examples 4-6 and 1000 or more were confirmed in Examples 1-3 and 7-9.

A SEM photograph (300× magnification) of a cross-section of a test piece using the spherical amorphous silica powder in Example 1 is shown in FIG. 1. A SEM photograph (300× magnification) of a cross-section of a test piece using the spherical amorphous silica powder in Comparative Example 1 is shown in FIG. 2.

As indicated in Table 1, it is clear that, for Examples 1-3 and 7-9, in a cross-section of a cured body containing an epoxy resin and a spherical inorganic oxide powder at a mass ratio of 2:1, when a total of 1000 particles with a maximum diameter of 20 μm or larger were observed in a field of view at 100× magnification using a scanning electron microscope, the number of air bubbles having a maximum diameter of 1 μm or larger and smaller than 10 μm was 40 or fewer and the number of air bubbles having a maximum diameter of 10 μm or larger was 30 or fewer.

(Impurity content)

A spherical amorphous silica powder was converted to a solution with fluoronitric acid, and the U, Th, Fe, and Al contents were measured with an inductively coupled plasma mass spectrometer (ICP-MS). The results are indicated in Table 1.

[Table 1]

| | | EX. 1 | EX. 2 | EX. 3 | EX. 4 | EX. 5 | EX. 6 | EX. 7 | EX. 8 | EX. 9 | COMP. EX. 1 | COMP. EX. 2 | COMP. EX. 3 | COMP. EX. 4 | COMP. EX. 5 | COMP. EX. 6 | COMP. EX. 7 | COMP. EX. 8 | COMP. EX. 9 |
|---|---|---|---|---|---|---|---|---|---|---|---|---|---|---|---|---|---|---|---|
| RAW MATERIAL BEFORE MELTING | COMPARATIVE RAW MATERIAL 3 (50 μm) | | | | | | | | | | ○ | ○ | ○ | | | | ○ | ○ | ○ |
| | COMPARATIVE RAW MATERIAL 4 (5 μm) | | | | | | | | | | | | | ○ | ○ | ○ | ○ | ○ | ○ |
| | RAW MATERIAL POWDER 1 (50 μm) | ○ | ○ | ○ | | | | ○ | ○ | ○ | | | | | | | | | |
| | RAW MATERIAL POWDER 2 (5 μm) | | | | ○ | ○ | ○ | ○ | ○ | ○ | | | | | | | | | |
| PARTICLE SIZE DISTRIBUTION | VOLUME-BASED CUMULATIVE 50% DIAMETER $D_{50}$ (μm) | 38.7 | 48.3 | 52.8 | 4.2 | 7.5 | 8.9 | 8.2 | 14.7 | 25.9 | 40.6 | 45.2 | 49.4 | 4.5 | 6.9 | 8.1 | 9.5 | 12.1 | 22.4 |
| | NUMBER OF PEAKS IN FREQUENCY DATA | 1 | 1 | 1 | 1 | 1 | 1 | 2 | 2 | 2 | 1 | 1 | 1 | 1 | 1 | 1 | 2 | 2 | 2 |

| | | EX. 1 | EX. 2 | EX. 3 | EX. 4 | EX. 5 | EX. 6 | EX. 7 | EX. 8 | EX. 9 | COMP. EX. 1 | COMP. EX. 2 | COMP. EX. 3 | COMP. EX. 4 | COMP. EX. 5 | COMP. EX. 6 | COMP. EX. 7 | COMP. EX. 8 | COMP. EX. 9 |
|---|---|---|---|---|---|---|---|---|---|---|---|---|---|---|---|---|---|---|---|
| CROSS-SECTIONAL SEM | TOTAL NUMBER OF PARTICLES (LONG DIAMETER 5 $\mu$m OR MORE) | 5000 | 5000 | 5000 | 5000 | 5000 | 5000 | 5000 | 5000 | 5000 | 5000 | 5000 | 5000 | 5000 | 5000 | 5000 | 5000 | 5000 | 5000 |
| | 10 $\mu$m OR LARGER VOID CONTENT (NUMBER OF AIR BUBBLES) | 2 | 4 | 0 | 1 | 0 | 6 | 0 | 2 | 4 | 51 | 61 | 29 | 12 | 11 | 25 | 34 | 57 | 94 |
| | 1 $\mu$m OR LARGER/ SMALLER THAN 10 $\mu$m VOID CONTENT (NUMBER OF AIR BUBBLES) | 4 | 5 | 2 | 23 | 15 | 29 | 0 | 3 | 7 | 76 | 88 | 41 | 34 | 46 | 53 | 47 | 71 | 104 |
| ICP-MASS | U (ppb) | 1.1 | 5.4 | 0.2 | 0.1 | 0.3 | 2.4 | 0.1 | 0.2 | 3.4 | 10.4 | 8.9 | 0.8 | 11.8 | 2.5 | 7.4 | 8.4 | 14.5 | 0.6 |
| | Th (ppb) | 1.4 | 10.2 | 0.3 | 0.1 | 0.2 | 4.5 | 0.1 | 0.4 | 4.7 | 15.5 | 7.5 | 0.8 | 17.4 | 4.6 | 10.2 | 10.5 | 16.1 | 0.4 |
| | Fe (ppm) | 40 | 50 | 10 | 80 | 20 | 60 | 20 | 30 | 110 | 20 | 50 | 40 | 30 | 20 | 60 | 10 | 30 | 30 |
| | Al (ppm) | 140 | 520 | 910 | 210 | 1150 | 3100 | 170 | 1780 | 8120 | 290 | 350 | 880 | 1240 | 2140 | 4600 | 380 | 3750 | 7580 |

EP 4 317 065 A1

**Claims**

1. A spherical inorganic oxide powder wherein:

   a volume-based cumulative 50% diameter $D_{50}$ is 4-55 $\mu$m; and
   in a cross-section of a cured body containing an epoxy resin and the spherical inorganic oxide powder at a mass ratio of 2:1, when a total of 5000 particles with a maximum diameter of 5 $\mu$m or larger are observed in a field of view at 100× magnification using a scanning electron microscope, a total number of air bubbles having a maximum diameter of 1 $\mu$m or larger and smaller than 10 $\mu$m is 40 or fewer and a total number of air bubbles having a maximum diameter of 10 $\mu$m or larger is 30 or fewer.

2. The spherical inorganic oxide powder according to claim 1, wherein, in a cross-section of a cured body containing an epoxy resin and the spherical inorganic oxide powder at a mass ratio of 2:1, when a total of 5000 particles with a maximum diameter of 5 $\mu$m or larger are observed in a field of view at 100× magnification using a scanning electron microscope, 1000 or more particles having a maximum diameter of 20 $\mu$m or larger are observed.

3. The spherical inorganic oxide powder according to claim 1 or 2, wherein, in a cross-section of a cured body containing an epoxy resin and the spherical inorganic oxide powder at a mass ratio of 2:1, when a total of 1000 particles with a maximum diameter of 20 $\mu$m or larger are observed in a field of view at 100× magnification using a scanning electron microscope, a total number of air bubbles having a maximum diameter of 1 $\mu$m or larger and smaller than 10 $\mu$m is 40 or fewer and a total number of air bubbles having a maximum diameter of 10 $\mu$m or larger is 30 or fewer.

4. The spherical inorganic oxide powder according to any one of claims 1 to 3, wherein the volume-based cumulative 50% diameter $D_{50}$ is 7.5 $\mu$m or larger.

5. The spherical inorganic oxide powder according to any one of claims 1 to 4, having at least two peaks in a volume-based particle size frequency distribution.

6. The spherical inorganic oxide powder according to any one of claims 1 to 5, satisfying one or more conditions selected from the following:

   - the U content is 10 ppb or less;
   - the Th content is 20 ppb or less;
   - the Fe content is 200 ppm or less; and
   - the Al content is 1 mass% or less.

7. A production method for a spherical inorganic oxide powder according to any one of claims 1 to 6, wherein the production method includes:

   (i) retaining a raw material containing an inorganic oxide for 3 hours or more under conditions with a pressure of 0.9-1.5 atm and a temperature of 1600 °C or higher to obtain a melted material, and after cooling the melted material, pulverizing and classifying the material to obtain a crushed powder; and
   (ii) thermally spraying the amorphous powder into a flame with a flame temperature of 1600 °C or higher to obtain a spherical inorganic oxide powder,

   thereby obtaining a spherical inorganic oxide powder having a volume-based cumulative 50% diameter $D_{50}$ of 4-55 $\mu$m.

8. The production method according to claim 7, including, before step (i), pulverizing a mineral and/or an ore containing the inorganic oxide to obtain the raw material.

[FIG. 1]

[FIG. 2]

## INTERNATIONAL SEARCH REPORT

| International application No. |
| --- |
| **PCT/JP2022/013370** |

| A. | CLASSIFICATION OF SUBJECT MATTER |
| --- | --- |

*C01B 33/12*(2006.01)i; *C01B 33/18*(2006.01)i; *H01L 23/29*(2006.01)i; *H01L 23/31*(2006.01)i
FI:   C01B33/12 E; C01B33/18 Z; H01L23/30 R

According to International Patent Classification (IPC) or to both national classification and IPC

| B. | FIELDS SEARCHED |
| --- | --- |

Minimum documentation searched (classification system followed by classification symbols)

C01B33/12; C01B33/18; H01L23/29; H01L23/31

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JSTChina/JST7580 (JDreamIII)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | WO 2019/167618 A1 (TOKUYAMA CORPORATION) 06 September 2019 (2019-09-06) claims, table 1 | 1-8 |
| A | JP 2004-203664 A (DENKI KAGAKU KOGYO KK) 22 July 2004 (2004-07-22) claims, paragraphs [0031], [0035] | 1-8 |
| A | WO 2019/177112 A1 (DENKA COMPANY LIMITED) 19 September 2019 (2019-09-19) claims, paragraphs [0001], [0055], [0056] | 1-8 |
| A | JP 2013-249218 A (MITSUBISHI MATERIALS CORP) 12 December 2013 (2013-12-12) claims | 1-8 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **15 April 2022** | **26 April 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/013370**

| Patent document cited in search report | | | Publication date (day/month/year) | Patent family member(s) | | | Publication date (day/month/year) |
|---|---|---|---|---|---|---|---|
| WO | 2019/167618 | A1 | 06 September 2019 | CN | 111629998 | A | |
| | | | | KR | 10-2020-0127159 | A | |
| | | | | TW | 201936498 | A | |
| JP | 2004-203664 | A | 22 July 2004 | (Family: none) | | | |
| WO | 2019/177112 | A1 | 19 September 2019 | US | 2020/0399169 | A1 | |
| | | | | claims, paragraphs [0002], [0056]-[0058] | | | |
| | | | | EP | 3766852 | A1 | |
| | | | | CN | 111630011 | A | |
| | | | | KR | 10-2020-0133325 | A | |
| | | | | SG | 11202006825Q | A | |
| | | | | TW | 201940456 | A | |
| JP | 2013-249218 | A | 12 December 2013 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010285307 A
- WO 2019167618 A
- JP S58145613 A
- JP S5959737 A
- JP S61234922 A
- JP H656445 A